# EUROPEAN PATENT APPLICATION

(11) **EP 4 750 259 A1**
(43) Date of publication of application: **27.05.2026**
(21) Application number: 25210347.8
(22) Date of filing: 22.10.2025
(51) Int. Cl.: H10D 84/01, H10D 30/01, H10D 84/83, H10D 84/85, H10D 64/27, H10D 30/00

(54) **FORKSHEET FET DEVICE INCLUDING GATE EXTENSION AND METHOD FOR FABRICATING THE SAME**

(30) Priority: 21.11.2024 US 202463723313 P; 13.02.2025 US 202519053025
(71) Applicant: Samsung Electronics Co., Ltd., Suwon-si, Gyeonggi-do 16677 (KR)
(72) Inventor: KUMAR, Aravindh, San Jose,, CA 95134 (US); KIM, Jong Chol, San Jose,, CA 95134 (US); SAREMI, Mehdi, San Jose,, CA 95134 (US); PARK, Rebecca, San Jose,, CA 95134 (US); AHOSAN UL KARIM, Muhammed, San Jose,, CA 95134 (US); SIMKA, Harsono, San Jose,, CA 95134 (US)
(74) Representative: Kuhnen & Wacker Patent- und Rechtsanwaltsbüro PartG mbB

(57) **Abstract**

A forksheet FET device and processes for fabricating the same are provided. A semiconductor device includes a dielectric wall; a first semiconductor layer extending in a first direction perpendicular from a first side of the dielectric wall, the first semiconductor layer having a first end that is nearest to the dielectric wall; and a first gate electrode layer including a first gate extension that extends beyond the first end of the first semiconductor layer nearer to the first side of the dielectric wall.

## Description

### FIELD

The present application relates generally to field-effect transistor (FET) based devices, and particularly, to forksheet FET devices including a gate extension and processes for fabricating the same.

### BACKGROUND

A forksheet FET is an advanced variation of a nanosheet architecture, where a dielectric wall is added between n-channel metal-oxide semiconductor (NMOS) and p-channel metal-oxide semiconductor (PMOS) devices, i.e., nFET and pFET devices, allowing for a tighter arrangement.

More specifically, in forksheet FETs, both an nFET and a pFET are integrated in the same structure, wherein the dielectric wall separates the nFET and pFET. This allows for a tighter n-to-p spacing and reduction in area scaling.

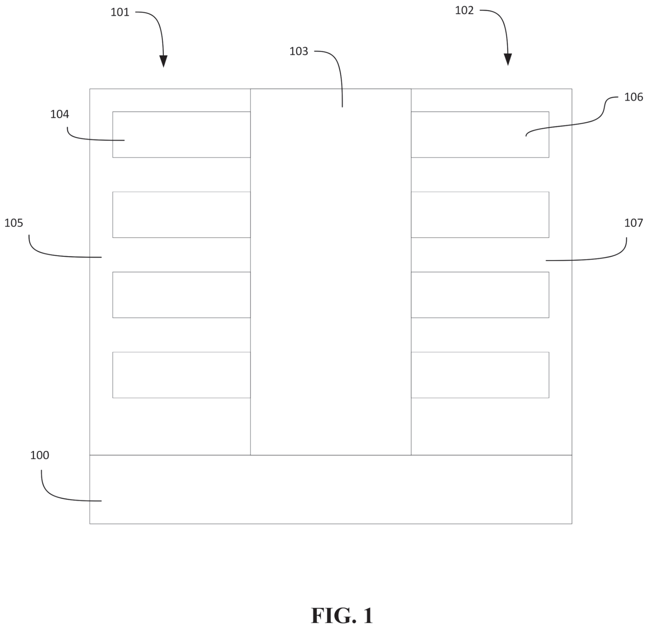

FIG. 1 illustrates a schematic view of the cross-section of a forksheet FET.

Referring to FIG. 1, the forksheet FET includes substrate 100, on which an nFET 101, a dielectric wall 103, and a pFET 102 are formed. As described above, the nFET 101 and the pFET 102 are separated by a dielectric wall 103 for tighter n-to-p spacing and a reduction in area scaling.

The nFET 101 includes a plurality of semiconductor layers (or channels) 104 (i.e., NMOS) extending in a horizontal direction (or substantially horizontal direction) from the dielectric wall 103 and a gate electrode layer 105 surrounding the semiconductor layers 104. The pFET 102 includes a plurality of semiconductor layers (or channels) 106 (i.e., PMOS) extending in a horizontal direction (or substantially horizontal direction) from the dielectric wall 103 and a gate electrode layer 107 surrounding the semiconductor layers 106.

However, while the forksheet FET may provide improvements over other FET devices, such as improved area scaling through space reduction between transistors and gate-drain capacitance reduction, capacitive coupling may still occur between the nFET 101 and the pFET 102 through the dielectric wall 103, which may lead to dynamic threshold voltage variation and/or degradation of a subthreshold swing.

### SUMMARY

Accordingly, an aspect of the present disclosure is provide an improved forksheet FET including a gate extension, which addresses capacitive coupling between a target device channel and an adjacent device gate.

Another aspect of the present disclosure is provide a method for fabricating a forksheet FET including a gate extension.

The gate extension enhances gate control and shielding by a target gate over a target channel, improving immunity against an adjacent gate and reducing dynamic threshold voltage variation.

According to an embodiment, a semiconductor device includes a dielectric wall; a first semiconductor layer extending in a first direction perpendicular from a first side of the dielectric wall, the first semiconductor layer having a first end that is nearest to the dielectric wall; and a first gate electrode layer including a first gate extension that extends beyond the first end of the first semiconductor layer nearer to the first side of the dielectric wall.

According to another embodiment, a method is provided fabricating a semiconductor device. The method includes forming an initial structure including a dielectric wall, a first semiconductor layer that contacts and extends in a first direction perpendicular from a first side of the dielectric wall, and a first gate electrode layer that surrounds each side of the first semiconductor layer that is not contacting the dielectric wall; removing the dielectric wall to create a trench; and removing a portion of the first semiconductor layer exposed to the trench to create a first recess.

### BRIEF DESCRIPTION OF THE DRAWINGS

In the following section, the aspects of the subject matter disclosed herein will be described with reference to exemplary embodiments illustrated in the figures, in which:
FIG. 1 illustrates a schematic view of the cross-section of a forksheet FET;
FIG. 2 illustrates a schematic view of a portion of forksheet FET including a gate extension, according to an embodiment;
FIG. 3 illustrates an example of performance comparisons of a forksheet FET including a gate extension having a different depths, according to an embodiment;
FIG. 4 illustrates a method of fabricating a forksheet FET including a gate extension, according to an embodiment;
FIG. 5 is a flowchart illustrating a method of fabricating a forksheet FET including a gate extension, according to an embodiment; and
FIG. 6 illustrates a schematic block diagram of an electronic system that may implement one or more electronic devices according to one or more embodiments of the present disclosure.

### DETAILED DESCRIPTION

Hereinafter, example embodiments will be described in more detail with reference to the accompanying drawings, in which like reference numbers may refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described.

In the drawings, the relative sizes of elements, layers, and regions may be exaggerated and/or simplified for clarity. Spatially relative terms, such as "beneath," "below," "lower," "under," "above," "upper," etc., may be used herein for ease of explanation to describe one element or feature's relationship to another element(s) or feature(s) as illustrated in the figures.

Spatially relative terms are intended to encompass different orientations of the device in use or in operation, in addition to the orientation depicted in the figures. For example, if a device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

Although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section.

When an element or layer is referred to as being "on," "connected to," or "coupled to" another element or layer, it can be directly on, connected to, or coupled to the other element or layer, or one or more intervening elements or layers may be present. In addition, when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present invention. As used herein, the singular forms "a" and "an" are intended to include the plural forms as well, unless the context clearly indicates otherwise. It will be further understood that the terms "comprises," "comprising," "includes," and "including," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure."

As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present invention belongs. Further, terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

An electronic or electric devices and/or any other relevant devices or components according to embodiments of the present disclosure described herein may be implemented utilizing any suitable hardware, firmware (e.g., an application-specific integrated circuit), software, or a combination of software, firmware, and hardware, to process data or digital signals. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Circuit hardware may include, for example, application specific integrated circuits (ASICs), general purpose or special purpose central processing units (CPUs) that is configured to execute instructions stored in a non-transitory storage medium, digital signal processors (DSPs), graphics processing units (GPUs), and programmable logic devices such as field programmable gate arrays (FPGAs).

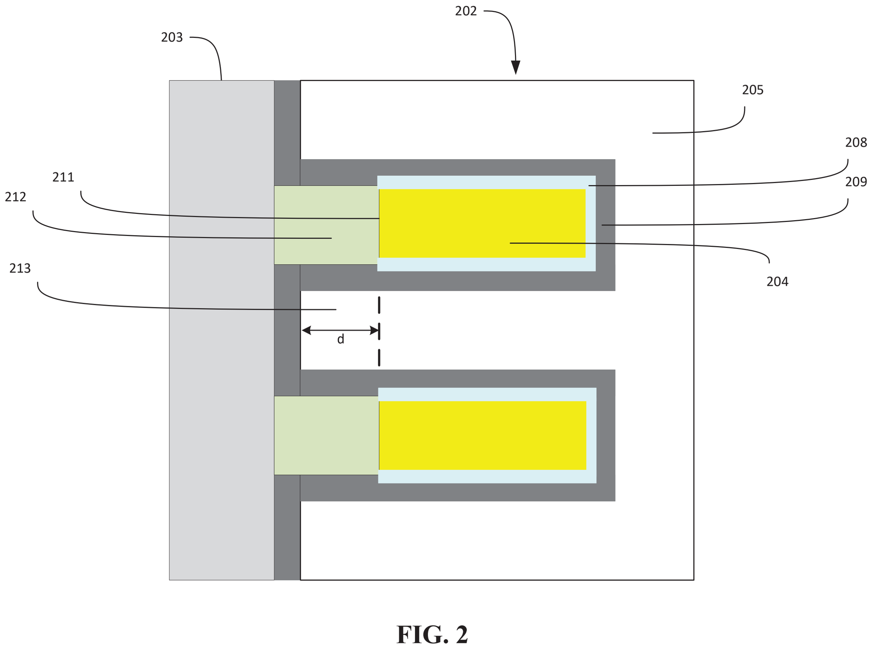

FIG. 2 illustrates a schematic view of a portion of a forksheet FET including a gate extension, according to an embodiment. More specifically, FIG. 2 illustrates one side of a forksheet FET including a gate extension.

Referring to FIG. 2, the forksheet FET includes a dielectric wall 203 and an FET 202. The FET 202 may be an nFET or a pFET.

The FET 202 includes a plurality of semiconductor layers 204 extending in a horizontal direction (or substantially horizontal direction) from the dielectric wall 203 and a gate electrode layer 205. Each of the semiconductor layers 204 include a first end 211, which is nearest to the dielectric wall 203.

Additionally, dielectric extensions 212 are provided, which space the semiconductor layers 204 from the dielectric wall 203. The dielectric wall 203 and the dielectric extensions 212 may be formed of the same material or different materials.

The FET 202 also includes an interfacial layer 208 (e.g., silicon oxide (SiOx) around the other sides of the semiconductor layers 204, i.e., not on the first ends 211, and a dielectric layer 209 having a high dielectric constant on the interfacial layer 208.

The gate electrode layer 205 is provided on the dielectric layer 209 (e.g., the dielectric layer 209 is between the interfacial layers 208 and the gate electrode layer 205).

The gate electrode layer 205 includes a gate extension 213, which has a depth d, extending beyond the first ends 211 of the semiconductor layers 204, towards the dielectric wall 203. The gate extension 213 enhances gate control and shielding by a target gate over a target channel, improving immunity against an adjacent gate (e.g., the FET on the other side of the dielectric wall 203) and reducing dynamic threshold voltage variation.

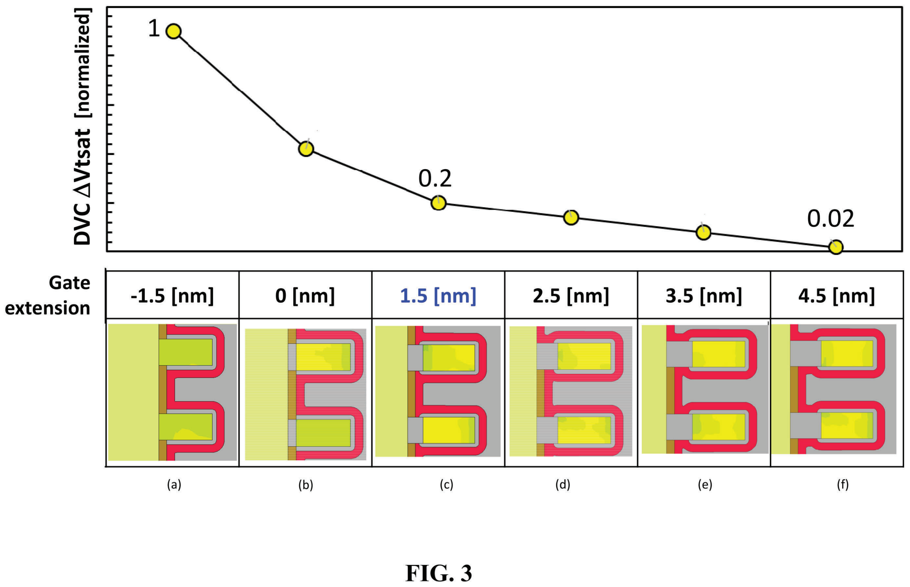

FIG. 3 illustrates an example of performance comparisons of a forksheet FET including a gate extension having a different depths, according to an embodiment.

Referring to FIG. 3, in scenario (a), where the forksheet FET includes a gate extension that has a depth d = -1.5 nm (technically, no gate exists as the first end of the semiconductor layer is closer to the dielectric wall than the gate electrode layer), the normalized measured device coupling (DVC) induced Vₜ variation (Δ Vₜₛₐₜ) is 1 mV.

In scenario (b), where the forksheet FET includes a gate extension that has a depth d = 0 nm (technically, no gate exists as the first end of the semiconductor layer and the gate electrode layer are equidistant from the dielectric wall), the normalized measured DVC Δ Vₜₛₐₜ drops significantly.

Additionally, in scenarios (c), (d), (e), and (f), where the forksheet FET includes a gate extension that has a depth d = 1.5 nm, 2.5 nm, 3.5 nm, and 4.5 nm, respectively, the normalized measured DVC Δ Vₜₛₐₜ continue to decrease at each increased depth. Accordingly, as the depth of the gate extension increases, the measured DVC Δ Vₜₛₐₜ decreases, improving performance of the forksheet FET. For example, the difference in normalized measured DVC Δ Vₜₛₐₜ between d = -1.5 nm and d = 1.5 nm is approximately 5x.

Although FIG. 3 includes normalized measured DVC Δ Vₜₛₐₜ values corresponding to each of the illustrated gate extension lengths, these values are just examples provided to illustrate the significant decrease in DVC Δ Vₜₛₐₜ, and the present disclosure is not limited thereto. For example, the values of DVC Δ Vₜₛₐₜ may vary not only on the gate extension lengths, but also the materials used in fabricating the forksheet FET.

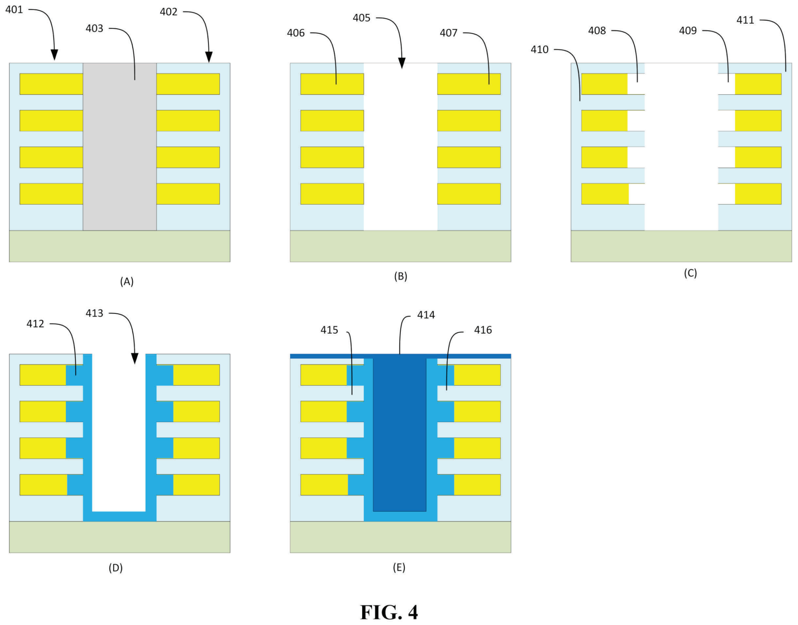

FIG. 4 illustrates a method of fabricating a forksheet FET including a gate extension, according to an embodiment.

Referring to FIG. 4, after fabricating a forksheet FET in (A), which includes an nFET 401 and a pFET 402, which are separated by a dielectric wall 403, e.g., as illustrated in FIG. 1, the dielectric wall 403 may be etched to a predetermined depth, as in (B), creating a trench 405 that exposes the inner edges of the semiconductor layers 406 and 407. Since the initial fabrication of the forksheet FET in (A) is not directly related to the present disclosure, a detailed description is omitted herein. For example, the initial fabrication of the forksheet FET in (A) may be done as described in U.S. 2024/0379409.

Thereafter, as shown in (C), the semiconductor layers 406 and 407 may be etched to from the trench 405 side to create recesses 408 and 409, such that gate electrodes layers 410 and 411 protrude horizontally beyond the semiconductor layers 406 and 407 into the trench 405. For example, assuming the semiconductor layers 406 and 407 in (B) are 25 nm in width, the recesses 408 and 409 may be 4 nm deep, leaving the semiconductor layers 406 and 407 in (C) with a width of 21 nm.

The depth in which the semiconductor layers 406 and 407 are etched from the trench 405 side factors in the depth d of the gate extension.

Thereafter, as shown in (D), the recesses 408 and 409, as well as portion of the trench 405, may be filled with a wall dielectric 412, e.g., silicon dioxide (SiO₂), silicon monoxide (SiO), creating a smaller trench 413.

As shown in (E), the smaller trench 413 may be filled with another wall dielectric 414, e.g., silicon nitride (SiN), completing the forksheet FET including gate extensions 415 and 416.

Although FIG. 4 illustrates a two-step process of filing the recesses 408 and 409 and the trench 405 using two different wall dielectrics, the disclosure is not limited thereto. For example, the recesses 408 and 409 and the trench 405 may be filled in one step using one wall dielectric, or the smaller trench 413 may be filled with a suitable non-dielectric material.

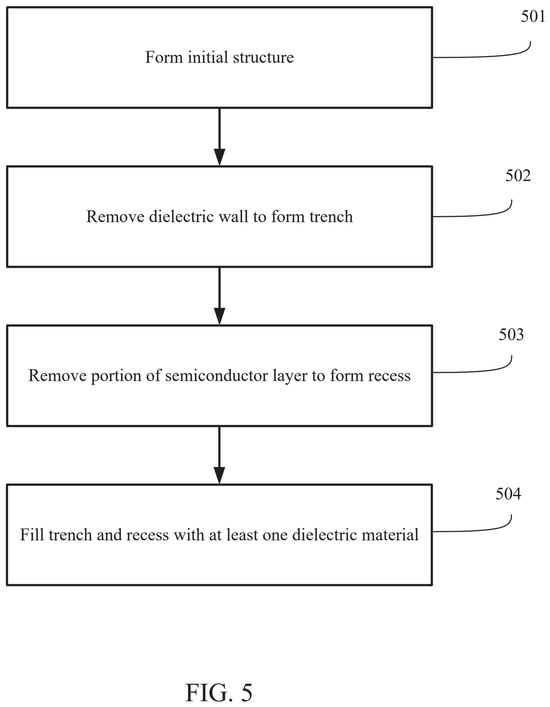

FIG. 5 is a flowchart illustrating a method of fabricating a forksheet FET including a gate extension, according to an embodiment.

Referring to FIG. 5, in step 501, an initial structure is formed, which includes a dielectric wall, a first semiconductor layer that contacts and extends in a first direction perpendicular from a first side of the dielectric wall, and a first gate electrode layer that surrounds each side of the first semiconductor layer that is not contacting the dielectric wall. As described above, this initial structure may be formed as described in U.S. 2024/0379409.

In step 502, the dielectric wall is removed to create a trench, e.g., the trench 405 as in (B) in FIG. 4.

In step 503, a portion of the first semiconductor layer exposed to the trench is removed to create a first recess, e.g., the recesses 408 as in (C) in FIG. 4.

In step 504, the trench and the first recess are filled with at least one dielectric material, e.g., as shown in (D) and (E) in FIG. 4. As described above, the dielectric material in the first recess allows a gate extension to be created, which extends beyond the first end of a first semiconductor layer nearer to a first side of the dielectric wall.

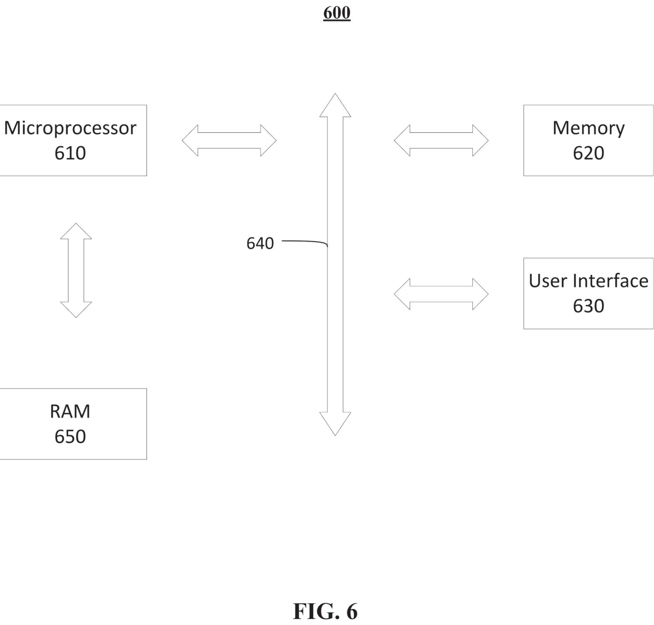

FIG. 6 illustrates a schematic block diagram of an electronic system that may implement one or more electronic devices according to one or more embodiments of the present disclosure.

Referring to FIG. 6, an electronic system 600 in accordance with one or more embodiments may include a microprocessor 610, a memory 620, and a user interface 630 that perform data communication using a bus 640. The microprocessor 610 may include a central processing unit (CPU) or an application processor (AP). The electronic system 600 may further include a random access memory (RAM) 650 in communication with the microprocessor 610. The microprocessor 610 and/or the RAM 650 may be implemented in a single module or package. The user interface 630 may be used to input data to the electronic system 600, or output data from the electronic system 600. For example, the user interface 630 may include a keyboard, a touch pad, a touch screen, a mouse, a scanner, a voice detector, a liquid crystal display (LCD), a micro light-emitting device (LED), an organic light-emitting diode (OLED) device, an active-matrix light-emitting diode (AMOLED) device, a printer, a lighting, or various other input/output devices without limitation. The memory 620 may store operational codes of the microprocessor 610, data processed by the microprocessor 610, or data received from an external device. The memory 620 may include a memory controller, a hard disk, or a solid state drive (SSD).

At least the microprocessor 610, the memory 620 and/or the RAM 650 in the electronic system 600 may include one or more forksheet FET structures described in the above embodiments.

While this disclosure may contain many specific implementation details, the implementation details should not be construed as limitations on the scope of any claimed subject matter, but rather be construed as descriptions of features specific to particular embodiments. Certain features that are described in this disclosure in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

## Claims

1. A semiconductor device, comprising:
a dielectric wall;
a first semiconductor layer extending in a first direction perpendicular from a first side of the dielectric wall, the first semiconductor layer having a first end that is nearest to the dielectric wall; and
a first gate electrode layer including a first gate extension that extends beyond the first end of the first semiconductor layer nearer to the first side of the dielectric wall.

2. The semiconductor device of claim 1, further comprising a first dielectric extension between the first end of the first semiconductor layer and the first side of the dielectric wall.

3. The semiconductor device of claim 2, wherein the first dielectric extension includes silicon dioxide.

4. The semiconductor device of any one of the previous claims, further comprising a first interfacial dielectric layer that surrounds the first semiconductor layer, except for the first end.

5. The semiconductor device of claim 4, wherein the first interfacial dielectric layer includes silicon dioxide.

6. The semiconductor device of claim 4 or 5, further comprising a first dielectric layer between the first interfacial dielectric layer and the first gate electrode layer.

7. The semiconductor device of any one of the previous claims, further comprising:
a second semiconductor layer extending in a second direction perpendicular from a second side of the dielectric wall, the second semiconductor layer having a first end that is nearest to the dielectric wall; and
a second gate electrode layer including a second gate extension that extends beyond the first end of the second semiconductor layer nearer to the second side of the dielectric wall.

8. The semiconductor device of claim 7, further comprising a second dielectric extension between the first end of the second semiconductor layer and the second side of the dielectric wall.

9. The semiconductor device of claim 7 or 8, further comprising a second interfacial layer that surrounds the second semiconductor layer, except for the first end.

10. The semiconductor device of claim 9, further comprising a second dielectric layer between the second interfacial layer and the second gate electrode layer.

11. A method of fabricating a semiconductor device, the method comprising:
forming an initial structure including:
a dielectric wall,
a first semiconductor layer that contacts and extends in a first direction perpendicular from a first side of the dielectric wall, and
a first gate electrode layer that surrounds each side of the first semiconductor layer that is not contacting the dielectric wall;
removing the dielectric wall to create a trench; and
removing a portion of the first semiconductor layer exposed to the trench to create a first recess.

12. The method of claim 11, further comprising filling the trench and the first recess with at least one dielectric material.

13. The method of claim 12, wherein filling the trench and the first recess with at least one dielectric material comprises:
filing the first recess and a portion of the trench with a first dielectric material; and
filing a remaining portion of the trench with a second dielectric material.

14. The method of claim 13, wherein the first dielectric material includes silicon dioxide.

15. The method of claim 13 or 14, wherein the second dielectric material includes silicon nitride.
